# EUROPÄISCHE PATENTSCHRIFT

(11) **EP 1 110 060 B1**
(45) Veröffentlichungstag und Bekanntmachung des Hinweises auf die Patenterteilung: **19.02.2003**
(21) Anmeldenummer: 99953525.5
(22) Anmeldetag: 06.08.1999
(51) Int. Cl.: G01F 23/22, G01N 24/08, C01B 3/00

(54) **VORRICHTUNG UND VERFAHREN ZUM MESSEN DER MENGE EINES GASFÖRMIGEN MEDIUMS IN EINEM SPEICHERBEHÄLTER**
DEVICE AND METHOD FOR STORING A GASEOUS MEDIUM IN A STORAGE CONTAINER
DISPOSITIF ET PROCEDE POUR MESURER LA QUANTITE DE FLUIDE GAZEUX CONTENU DANS UN RESERVOIR DE STOCKAGE

(30) Priorität: 19.08.1998 DE 19838664
(43) Veröffentlichungstag der Anmeldung: 27.06.2001
(73) Patentinhaber: Vodafone AG, 40213 Düsseldorf (DE)
(72) Erfinder: SCHÜTZ, Walter, D-95466 Weidenberg (DE)
(74) Vertreter: Meissner, Peter E., Dipl.-Ing.
(86) Internationale Anmeldenummer: DE9902503
(87) Internationale Veröffentlichungsnummer: WO00011438

(56) Entgegenhaltungen:
- WO-A-97/19363
- WO-A-97/26082
- DE-A- 19 745 549
- US-A- 5 122 746

## Beschreibung

Die vorliegende Erfindung betrifft eine Vorrichtung zum Speichern von gasförmigen Medien, mit einem Speicherbehälter zur Aufnahme des zu speichernden Mediums gemäß dem Gattungsbegriff des Patentanspruchs 1. Weiterhin betrifft die Erfindung auch ein Verfahren zum Messen des Füllstands eines Mediums in einem Speicherbehälter.

Bei der Speicherung von gasförmigen Medien in entsprechenden Speicherbehältern, beispielsweise bei der Speicherung von gasförmigen Treibstoffen wie Wasserstoff oder Erdgas in dafür geeigneten Tanksystemen, stellt die Bestimmung des Füllstands, d.h. der gespeicherten Menge des gasförmigen Mediums in dem Speicherbehälter ein wesentliches Problem dar.

Bisher wird der Füllstand in der Regel indirekt über die abgegebene Menge des gasförmigen Mediums bestimmt. Diese Meßmethode weist jedoch eine Reihe von Nachteilen auf. So ist zunächst eine genaue Kenntnis der anfänglich gespeicherten Menge des gasförmigen Mediums erforderlich. Weiterhin können mögliche Verluste, die beispielsweise durch Lecks im Speicherbehälter entstehen können, durch die bekannte Meßmethode nicht berücksichtigt werden, so daß hier Ungenauigkeiten auftreten können. Durch die Tatsache, daß bei der bekannten indirekten Meßmethode die genauen Abfülldaten erforderlich sind, um Aussagen über den Füllstand des gasförmigen Mediums im Speicherbehälter machen zu können, ist diese Meßmethode insbesondere bei Tanksystemen zur Speicherung von gasförmigen Treibstoffen wenig geeignet.

Eine weitere Möglichkeit zur Messung des Füllstands eines gasförmigen Mediums in einem Speicherbehälter besteht in der Messung des im Speicherbehälter herrschenden Drucks. Der im Speicherbehälter herrschende Druck gibt in Abhängigkeit von der herrschenden Temperatur indirekt Auskunft über die Menge des gespeicherten gasförmigen Mediums. Diese Meßmethode kann aber nur dann eingesetzt werden, wenn die gasförmigen Medien mit einem erhöhten Druck im Speicherbehälter gespeichert werden bzw. eine direkte Proportionalität zwischen Druck und gespeicherter Menge besteht.

Aus der WO 97/19 363 ist eine Meßvorrichtung zur Bestimmung des Füllstandes eines insbesondere für die Raumfahrt nutzbaren Gasdruckbehälters bekannt. Diese Meßvorrichtung basiert auf dem Prinzip der kemmagnetischen Resonanz und weist ein Mittel zur Erzeugung eines im wesentlichen gleichförmigen magnetischen Feldes entlang einer Achse des Gasdruckbehälters und ein Mittel zur Erzeugung eines oszillierenden Magnetfeldes quer zu dem gleichförmigen Magnetfeld auf. Die Mittel zur Erzeugung der beiden Magnetfelder sind jeweils als elektrische Wicklungen ausgebildet, die den Gasdruckbehälter außen umgeben. Eine solche Konstruktion erfordert für jede Behälterform jeweils angepaßte elektrische Wicklungen.

Weiterhin ist es aus der US 5 539 309 bekannt, chemische oder physikalische Eigenschaften von Proben mit Hilfe des Prinzips der kernmagnetischen Resonanz zu ermitteln. Hierzu werden Probenbehälter mit festem oder flüssigem Inhalt in einen Untersuchungsbereich eingebracht, der in einem statischen Magnetfeld liegt. Zur Erzeugung der kernmagnetischen Resonanz wird die Probe mit einer elektrischen Wicklung umgeben, die ein magnetisches Wechselfeld senkrecht zu dem statischen Magnetfeld erzeugt. Das Problem einer Füllstandsmessung von Gasdruckbehältern wird in dieser Schrift nicht angesprochen.

Ausgehend vom genannten Stand der Technik liegt der vorliegenden Erfindung die Aufgabe zugrunde, eine Vorrichtung zum Speichern eines gasförmigen Mediums in einem Speicherbehälter derart weiterzubilden, daß die genannten Nachteile vermieden werden. Insbesondere soll eine Vorrichtung mit möglichst hoher Speicherkapazität geschaffen werden, bei der der Füllstand des gasförmigen Mediums auf einfache, genaue und unkomplizierte Weise direkt bestimmt werden kann, ohne daß Angaben über die Historie der Abfüll- und Entnahmevorgänge erforderlich sind und ohne daß unkontrollierte Verluste durch Lecks oder dergleichen das Meßergebnis verfälschen. Weiterhin soll ein Verfahren zum Messen des Füllstands eines gasförmigen Mediums in einem Speicherbehälter geschaffen werden.

Die Aufgabe wird gemäß dem ersten Aspekt der Erfindung gelöst durch eine Vorrichtung zum Speichern eines gasförmigen Mediums, mit einem Speicherbehälter, zur Aufnahme des gasförmigen Mediums, wobei der Speicherbehälter mit einer Speichermasse zum Speichern des gasförmigen Mediums gefüllt ist, dadurch gekennzeichnet, daß eine Meßvorrichtung zur Messung der kernmagnetischen Resonanz des im Speicherbehälter befindlichen gasförmigen Mediums vorgesehen ist, wobei die Meßvorrichtung ein statisches Magnetfeld und ein elektromagnetisches Wechselfeld erzeugt, dessen Feldlinien senkrecht auf den Feldlinien des statischen Magnetfeldes stehen, daß die Meßvorrichtung einen Meßkopf aufweist, in dem das statische Magnetfeld und das elektromagnetische Wechselfeld erzeugt werden, und daß der Meßkopf innerhalb des Speicherbehälters oder in einem mit dem Speicherbehälter strömungstechnisch verbundenen Meßrohr in der Weise angeordnet ist, daß er ein Teilvolumen des Speicherbehälters erfaßt, wobei das Teilvolumen hinsichtlich der Füllung mit der Speichermasse und dem gespeicherten gasförmigen Medium repräsentativ ist für den gesamten Speicherbehälter.

Dadurch wird die Möglichkeit geschaffen, daß der Füllstand des gespeicherten Mediums direkt gemessen werden kann. Außer der Art des gespeicherten Mediums und der Temperatur sind besondere zusätzliche Kenntnisse über weitere Werte und Daten des Mediums wie Druck oder dessen Abfüllhistorie nicht erforderlich. Das Meßprinzip ist grundsätzlich für alle Medien geeignet, die Atome aufweisen, deren Atomkerne ein magnetisches Moment besitzen, also insbesondere Wasserstoff.

Der Grundgedanke der vorliegenden Erfindung besteht darin, daß zur Bestimmung des Füllstands die kernmagnetische Resonanz (NMR-Resonanz (nuclear magnetic resonance)) des gespeicherten Mediums gemessen wird. Hierbei wird von dem Prinzip Gebrauch gemacht, daß einige Atomkerne wie zum Beispiel die von Wasserstoff ein kernmagnetisches Moment (Kernspin) besitzen. Dieses steht in Wechselwirkung mit einem äußeren magnetischen Feld. Im Falle von Wasserstoff, der hier zum besseren Verständnis exemplarisch eingehender betrachtet wird, allerdings ohne die Erfindung auf Wasserstoff zu beschränken, kann sich das magnetische Moment durch das äußere magnetische Feld parallel oder antiparallel zu dem angelegten Magnetfeld einstellen. Die beiden Einstellmöglichkeiten sind energetisch unterschiedlich, so daß zwei verschiedene Energieniveaus existieren. Diese Energieniveaus sind im thermischen Gleichgewicht unterschiedlich besetzt. Das heißt, daß es im unteren Energieniveau mehr Kernspins als im oberen Energieniveau gibt. Die Mengenverteilung auf die beiden Energieniveaus ist lediglich von der Art des jeweiligen Mediums und von dessen Temperatur abhängig. Wenn das eingefüllte Medium nur relativ geringen Temperaturschwankungen unterliegt (beispielsweise +/- 10°C), kann je nach Anforderungen die Meßgenauigkeit der Temperatureinfluß vernachlässigt werden. Grundsätzlich gilt, daß der Unterschied in der Besetzung des Energieniveaus umso geringer ist, je höher die Temperatur des Mediums ist. Wird diesem System nun Energie in Form von elektromagnetischer Strahlung zugeführt, wobei die Menge an zugeführter Energie der Differenz der beiden Energieniveaus entspricht, werden Kernspins vom unteren in das obere Energieniveau befördert. Das Ergebnis läßt sich erfassen und im Hinblick auf die tatsächliche Befüllung des Speicherbehälters auswerten und übertragen.

Durch die Messung der kernmagnetischen Resonanz in einem von der Messung erfaßten Teilvolumen des Speicherbehälters wird es also möglich, mittels Extrapolation im Hinblick auf das Gesamtvolumen den Füllstand des im Speicherbehälter gespeicherten Mediums über die tatsächlich vorherrschende Menge an darin befindlichen Atomkernen des Mediums zu bestimmen. Es bedarf hierzu lediglich einer entsprechenden Eichung bezüglich des jeweils vorliegenden Speichervolumens, damit die ermittelten Meßwerte in Abhängigkeit vom Temperaturniveau jeweils bestimmten Füllständen zugeordnet werden können.

Dadurch, daß im Speicherbehälter zusätzlich eine wie weiter unten näher beschriebene Speichermasse vorgesehen ist, kann ein zu speicherndes ursprünglich gasförmiges Medium derart mit der Speichermasse in Wechselwirkung treten, daß es während der Speicherung seine gasförmigen Eigenschaften verliert. Trotz dieser Besonderheit kann der Füllstand mit Hilfe der erfindungsgemäß vorgesehenen Meßvorrichtung zuverlässig bestimmt werden. Es ist lediglich sicherzustellen, daß das meßtechnisch erfaßte Teilvolumen auch im Hinblick auf die Speichermasse repräsentativ für das Gesamtvolumen ist.

Bevorzugte Ausführungsformen der erfindungsgemäßen Vorrichtung ergeben sich aus den rückbezogenen Unteransprüchen.

Erfindungsgemäß kann die kernmagnetische Resonanz des gespeicherten Mediums über die CW-Methode bestimmt werden. "CW" steht im Sinne der vorliegenden Erfindung für "continous wave" und bedeutet grundsätzlich, daß bei der Messung entweder das statische Magnetfeld oder das elektromagnetische Wechselfeld kontinuierlich verändert wird (z.B. Frequenz), während das jeweils andere Feld unverändert bleibt. Stimmt die Energie des elektromagnetischen Wechselfelds mit der Energieaufspaltung der beiden Kernspinniveaus, die von der Größe des statischen Magnetfelds abhängt, überein, so wird Energie absorbiert. Die absorbierte Energie ist proportional zur Anzahl der Kernspins in dem von der Messung erfaßten Volumenbereich und damit auch proportional zum Füllstand des im Speicherbehälter gespeicherten Mediums.

In einer anderen Ausgestaltungsform kann die kernmagnetische Resonanz des gespeicherten Mediums über die Fouriertransform-Methode bestimmt werden. Hierbei bleibt das statische Magnetfeld konstant. Das elektromagnetische Wechselfeld wird als Puls auf das gespeicherte Medium eingestrahlt. Nach dem Puls "antwortet" das gespeicherte Medium. Dieses Antwortsignal ist mit dem in der oben genannten CW-Methode beschriebenen Signal über Fouriertransformation verknüpft.

In einer weiteren Ausgestaltungsform kann die kernmagnetische Resonanz des gespeicherten Mediums bei konstantem statischen Magnetfeld und bei konstantem elektromagnetischen Wechselfeld detektiert werden.

Erfindungsgemäß weist die Vorrichtung einen Meßkopf auf, der ein bestimmtes Teilvolumen des Speicherbehälters erfaßt, das in gleicher Weise mit dem Medium gefüllt ist wie die übrigen Bereiche des Speicherbehälters. In dem Meßkopf ist ein statisches Magnetfeld und ein elektromagnetisches Wechselfeld vorhanden, wobei die Feldlinien des statischen Magnetfelds und des elektromagnetischen Wechselfelds senkrecht aufeinander stehen.

Durch das statische Magnetfeld werden die Kernspins auf ihre unterschiedlichen Energieniveaus eingestellt. Durch das elektromagnetische Wechselfeld, das in seiner Größe der Energiedifferenz zwischen den Energieniveaus entspricht, werden Kernspins vom unteren in das obere Energieniveau befördert. Die Energiedifferenz zwischen den Energieniveaus ist direkt proportional zum angelegten elektromagnetischen Wechselfeld. Je mehr Kernspins sich innerhalb des Meßkopfs befinden, desto mehr Energie kann absorbiert werden, so daß die absorbierte Energie auch direkt proportional zur Anzahl der Kernspins ist.

Bevorzugt weist der Meßkopf eine Meßspule auf, über die das elektromagnetische Wechselfeld eingekoppelt oder einkoppelbar ist. Zur genauen Messung des Füllstands eines in einem Speicherbehälter gespeicherten Mediums ist es in diesem Falle notwendig, daß sich im Bereich der Meßspule ein repräsentativer Teil des gespeicherten Mediums befindet, also eine gleichartige Zusammensetzung und volumetrische Verteilung sowie Temperatur des Mediums vorliegt. Zur Erhöhung der Meßgenauigkeit kann die erfindungsgemäße Vorrichtung mit einer Temperaturmeßeinrichtung ausgestattet sein, um die Abhängigkeit des Meßergebnisses von der Temperatur des Mediums mitberücksichtigen zu können. Bei vergleichsweise geringen zu erwartenden Schwankungen der Betriebstemperatur kann jedoch auf solche Temperaturmeßeinrichtungen völlig verzichtet werden. Zweckmäßigerweise wird dann die erfindungsgemäß vorgesehene Meßvorrichtung auf eine mittlere Betriebstemperatur geeicht.

In weiterer Ausgestaltung weist der Meßkopf einen Elektromagneten, insbesondere einen supraleitenden Magneten, und/oder einen Permanentmagneten auf, über den/die das statische Magnetfeld erzeugt oder erzeugbar ist. Natürlich sind die genannten Magnetarten sowohl einzeln, als auch in Kombination verwendbar.

In weiterer Ausgestaltung weist das elektromagnetische Wechselfeld eine Frequenz im Bereich von 10³ bis 10⁹ Hz auf. Vorteilhaft liegt die Frequenz im Bereich der Radiofrequenz, also im Megaherz-Bereich(MHz).

Die Ausgestaltung des Meßkopfs kann je nach Verwendung einer bestimmten Methode zur Messung der Kernresonanz, von denen zwei weiter oben genauer beschrieben wurden, unterschiedlich sein. Einige Ausgestaltungsvarianten, die jedoch rein exemplarischer Natur sind und nicht als abschließend zu verstehen sind, werden nachfolgend beschrieben.

Wird der Meßkopf bei der CW-Methode eingesetzt, kann das statische Magnetfeld beispielsweise durch einen Permanentmagneten (z.B. Hufeisenmagneten) erzeugt werden. In diesem Fall wird das statische Magnetfeld konstant gehalten. Das elektromagnetische Wechselfeld als variables Feld wird über eine Meßspule in den Meßkopf eingekoppelt. Die Veränderung des variablen elektromagnetischen Wechselfelds erfolgt über eine Veränderung der Frequenz. Die Meßspule wird vom Permanentmagneten derart umgeben, daß die jeweiligen Feldlinien senkrecht aufeinander stehen. Die Meßspule muß von einer repräsentativen Menge des gespeicherten Mediums durchdrungen sein.

Soll bei der CW-Methode beispielsweise das statische Magnetfeld variiert und das elektromagnetische Wechselfeld konstant gehalten werden, wird anstelle des Permanentmagneten ein Elektromagnet verwendet. Über den Elektromagneten, dessen Feldlinien wiederum senkrecht auf den Feldlinien des elektromagnetischen Wechselfelds stehen, läßt sich ein veränderliches statisches Magnetfeld erzeugen. Je nach Bedarf kann zusätzlich zu dem Elektromagneten noch ein weiterer Magnet, beispielsweise ein Permanentmagnet, zum Aufbau des statischen Magnetfelds verwendet werden. Über eine Meßspule wird das elektromagnetische Wechselfeld mit einer konstanten Frequenz eingekoppelt. Wiederum muß die Meßspule bei der Füllstandsmessung von einer repräsentativen Menge des gespeicherten Mediums durchdrungen sein.

Soll der Meßkopf bei der Fouriertransform-Methode verwendet werden, kann er beispielsweise einen Aufbau wie bei der oben beschriebenen Variante für die CW-Methode mit konstantem statischem Magnetfeld zeigen.

In weiterer Ausgestaltung ist ein Sender (Frequenzgenerator) zum Erzeugen des elektromagnetischen Wechselfelds vorgesehen. Der Sender ist vorzugsweise ein Hochfrequenzsender und dient als Strahlungsquelle für das elektromagnetische Wechselfeld.

Erfindungsgemäß ist weiterhin eine Brückenschaltung vorgesehen. Die Brückenschaltung fungiert als eine Art Weiche, die die Signale vom Sender an den Meßkopf, sowie die vom Meßkopf erzeugten Meßsignale an die anschließenden Auswerteeinheiten weiterleitet. Gleichzeitig verhindert die Brückenschaltung, daß die vom Sender abgehenden Signale direkt an die Auswerteeinheiten weitergeleitet werden, was dort zu Beschädigungen führen könnte. Weiterhin ermöglicht es die Brückenschaltung, etwa über ein Nullinstrument festzustellen, bei welcher Frequenz die Kerne des gespeicherten Mediums elektromagnetische Strahlung absorbieren.

Erfindungsgemäß kann weiterhin ein Verstärker vorgesehen sein. Dieser dient beispielsweise dazu, ein vom Meßkopf abgehendes Meßsignal für die weitere Verarbeitung entsprechend zu verstärken.

In weiterer Ausgestaltung kann eine Anzeigeeinrichtung vorgesehen sein. Die Anzeigeeinrichtung dient zur visuellen Anzeige der gemessenen Werte der kernmagnetischen Resonanz und damit auch zur Anzeige des Füllstands des im Speicherbehälter gespeicherten Mediums. Sie kann beispielsweise -jedoch nicht ausschließlich- als Schreiber, Skala, Bildschirm, Rechner oder dergleichen ausgebildet sein.

Durch die erfindungsgemäß vorgesehene Meßvorrichtung wird als ein Parameter ein für die Energieaufnahme infolge kernmagnetischer Resonanz repräsentativer Meßwert bestimmt und ausgewertet. Je höher der gemessene Wert ist, desto höher ist der Füllstand des im Speicherbehälter gespeicherten Mediums. Durch entsprechende Eichung können für das gespeicherte Medium den einzelnen Meßwerten bezogen auf den vorliegenden Speicherbehälter bestimmte Füllstände zugeordnet werden. Allerdings können auch weitere Parameter für die Auswertung herangezogen werden, beispielsweise die Relaxationszeiten, die sich in Abhängigkeit der Beladung des Speicherbehälters mit einem Medium, also proportional zu dessen Füllstand, verändern können. Als Relaxationszeit ist die Zeitspanne anzusehen, die vergeht, bis nach Abschalten des elektromagnetischen Wechselfeldes die ursprüngliche Verteilung der Kernspins auf die Energieniveaus wieder erreicht ist bzw. die Phasenkohärenz der Kernspins untereinander, die durch die Einstrahlung des elektromagnetischen Wechselfeldes erreicht wurde, verlorengegangen ist.

Erfindungsgemäß ist im Speicherbehälter eine Speichermasse zum Speichern des gasförmigen Mediums z.B. durch Adsorption, Absorption oder Chemiesorption vorgesehen. Die Speichermasse dient zur Erhöhung der Speicherkapazität für das Medium im Speicherbehälter. Die Verwendung einer Speichermasse ist daher insbesondere dann vorteilhaft, wenn die Speichervorrichtung als Tanksystem für mobile Anwendungen verwendet werden soll. Grundsätzlich kann je nach Bedarf, Anwendungsfall und zu speicherndem Medium jedes beliebige und in dem bestimmten Fall jeweils geeignete Material als Speichermasse verwendet werden..

Im folgenden wird exemplarisch eine Speichermasse beschrieben, die besonders geeignet ist für die Speicherung von Wasserstoff. Die Speicherung von Wasserstoff hat nämlich in den letzten Jahren rapide an Bedeutung gewonnen. So ist Wasserstoff beispielsweise als Treibstoff für mobile Anwendungen möglich, etwa als Treibstoff für Elektro-Fahrzeuge, die mit Brennstoffzellen zur Stromerzeugung betrieben werden.

Bevorzugt kann die Speichermasse aus Carbon-Nanostrukturen gebildet sein. Es sind bereits Vorschläge bekannt geworden, zur Speicherung von Gasen, und hier insbesondere von Wasserstoff, derartige Carbon-Nanostrukturen zu verwenden, die chemisorbierende Eigenschaften aufweisen. Ein solcher Vorschlag ist in der WO 97/26082 offenbart. Die Carbon-Nanostrukturen können beispielsweise in Form von Nanofasern (Nanofibers), Nanoröhrchen (Nanotubes) oder Nanoschuppen (Nanoshells) ausgebildet sein.

Erfindungsgemäß können die Carbon-Nanostrukturen eine ungerichtete oder gerichtete Struktur aufweisen und/oder bilden, wobei eine gerichtete Struktur bevorzugt wird.

Vorteilhaft können die Carbon-Nanostrukturen zu größeren zusammenhängenden Konglomeraten verbunden sein. Solche Konglomerate können beispielsweise die Form von Pellets, Scheiben, Tabletten oder dergleichen aufweisen. Auf diese Weise kann der Speicherbehälter leicht und unter größtmöglicher Raumausnutzung mit der Speichermasse für das zu speichernde Medium gefüllt werden.

In vorteilhafter Ausgestaltung ist die Speichermasse deshalb aus einer Anzahl von einzelnen zusammenhängenden Konglomeraten zusammengesetzt.

Erfindungsgemäß können zumindest einzelne der Konglomerate mit gegenüber der Scheindichte der ursprünglich losen Carbon-Nanostrukturen erhöhter Scheindichte verdichtet sein. Auf diese Weise kann bei vergleichsweise kleinem Speichervolumen des Speicherbehälters eine große Menge des gasförmigen Mediums gespeichert werden, da in das vorgegebene Speichervolumen des Speicherbehälters mehr Speichermasse eingebracht wird, als dies durch einfaches Einfüllen von Speichermasse möglich wäre. Als Scheindichte wird dabei das auf das Volumen des Konglomerats bezogene Gewicht verstanden. Eine wie vorstehend beschriebene Speichermasse aus Konglomeraten von Carbon-Nanostrukturen ist beispielsweise aus der DE-197 455 49.2 entnehmbar, die von der Anmelderin eingereicht wurde.

Vorteilhaft ist der Meßkopf (gemäß einer ersten Ausführungsform) innerhalb des Speicherbehälters angeordnet. Dabei ist eine bestimmte Anordnung innerhalb des ein Gas enthaltenden Speicherbehälters grundsätzlich nicht von besonderer Bedeutung. Wichtig ist lediglich, daß sich im Meßkopf eine repräsentative Menge des gespeicherten Mediums befindet, damit eine genaue Aussage über den Füllstand gemacht werden kann. Da sich das gespeicherte gasförmige Medium mit zunehmender Leerung des Speicherbehälters in gleichem Maße in diesem verteilt, ist die vorherrschende Menge des gespeicherten Mediums, die an einer bestimmten Stelle im Speicherbehälter gemessen wird, -anders als bei reinen Flüssigkeitsbehältern- repräsentativ für die Gesamtmenge des im Speicherbehälter gespeicherten Mediums. Somit kann auch mit einem relativ kleinen Meßkopf eine genaue Angabe des Füllstands des im Speicherbehälter gespeicherten Mediums erfolgen.

In manchen Fällen ist es vorteilhaft, den Meßkopf nicht unmittelbar im Speicherbehälter zu installieren, sondern (gemäß einer ersten Ausführungsform) in einem mit dem Inneren des Speicherbehälters unmittelbar strömungstechnisch verbundenen Meßrohr, so daß darin bezogen auf das gespeicherte Medium gleichartige Meßbedingungen herrschen wie im Speicherbehälter. Daher muß der Meßkopf erfindungsgemäß auch von der Speichermasse durchdrungen, d.h. in die Speichermasse eingebettet sein.

In bevorzugter Ausgestaltung ist das zu speichernde Medium Wasserstoff.

Der Umstand, daß das Medium in einer Speichermasse gespeichert wird, läßt die Vorteile der vorliegenden Erfindung besonders deutlich werden. Wie das folgende Beispiel zeigt, könnte nämlich, abgesehen von der für mobile Anwendungen vielfach nicht praktizierbaren Methode der Füllstandsbestimmung durch Gewichtsmessungen, mit herkömmlichen Methoden (z.B. durch Druckmessung) keine zufriedenstellende Bestimmung des Füllstandes erfolgen. Wenn beispielsweise ein Druckbehälter mit Carbon-Nanofasern als Speichermedium gefüllt ist, ergibt sich etwa für Wasserstoff eine andere Be- und Entladecharakteristik als bei einem üblichen Druckwasserstoffspeicher. Nach einer Beladung mit Wasserstoff bei Drücken oberhalb von z.B. 100 bar ist ein Teil des Wasserstoffs im Speichermedium chemiesorbiert. Bei der Entladung wird unterhalb eines bestimmten Druckniveaus der Wasserstoff aus den Fasern wieder freigesetzt. Das bedeutet, daß bis zu diesem niedrigeren Druckniveau die Wasserstoffentnahme im wesentlichen aus den Hohlräumen zwischen den Fasern erfolgt. Erst bei weiter absinkendem Druck setzt eine Desorption des Wasserstoffs ein, so daß der Abfluß des Wasserstoffs aus den Zwischenräumen der Carbon-Nanofasern durch den desorbierten Wasserstoff weitgehend kompensiert wird, der Druck also konstant bleibt. Die tatsächliche Befüllung mit Wasserstoff liegt daher weitaus höher, als es an sich dem jeweils gemessenen Druck (bei einem Druckbehälter ohne Speichermasse) entsprechen würde. Eine Messung durch die erfindungsgemäße Vorrichtung kann dagegen nicht nur die Menge des in den Zwischenräumen gespeicherten Wasserstoffs, sondern auch die Menge des in der Speichermasse chemiesorbierten Wasserstoffs erfassen.

Gemäß einem zweiten Aspekt der vorliegenden Erfindung wird ein Verfahren zum Messen des Füllstands eines gasförmigen Mediums in einer erfindungsgemäßen Speichervorrichtung bereitgestellt, das durch folgende Schritte gekennzeichnet ist: a) Erzeugen eines statischen Magnetfelds und eines elektromagnetischen Wechselfelds im Meßkopf, der im Speicherbehälter oder in einem mit dem Speicherbehälter strömungstechnisch verbundenen Meßrohrangeordnet ist; b) Messen der kernmagnetischen Resonanz des gespeicherten Mediums über den Meßkopf, wobei der Meßkopf von einer repräsentativen Menge der Speichermasse und des gespeicherten Mediums durchdrungen ist; und c) Anzeigen eines dem Füllstand entsprechenden Ergebnisses auf der Basis der gemessenen Werte in einer Anzeigeeinrichtung.

Durch das erfindungsgemäße Verfahren kann auf einfache Weise eine direkte Bestimmung des Füllstands des im Speicherbehälter gespeicherten Mediums vorgenommen werden, ohne daß die in der Beschreibungseinleitung genannten Nachteile auftreten. Zu den Vorteilen, Wirkungen, Effekten und der Funktionsweise des erfindungsgemäßen Verfahrens wird auf die vorstehenden Ausführungen zur erfindungsgemäßen Speichervorrichtung vollinhaltlich Bezug genommen und hiermit verwiesen.

In weiterer Ausgestaltung können die gemessenen Werte der kernmagnetischen Resonanz des gespeicherten Mediums vor dem Anzeigen in der Anzeigeeinrichtung aufbereitet und/oder weiterverarbeitet werden. Dies kann beispielsweise mit Hilfe eines Computers geschehen.

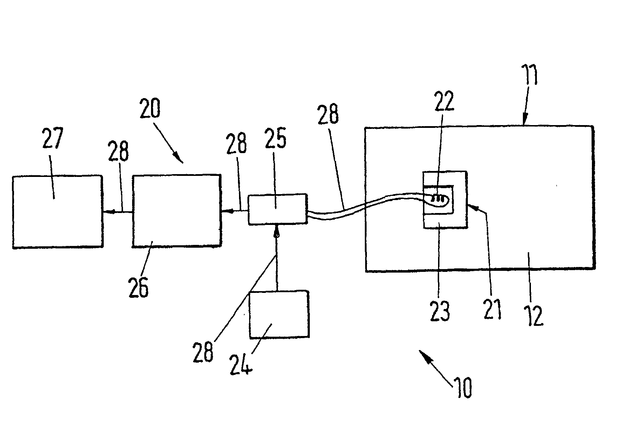

Die Erfindung wird nun anhand eines Ausführungsbeispiels unter Bezugnahme auf die beiliegende Zeichnung näher erläutert Dabei zeigt die einzige Figur den schematischen Aufbau einer erfindungsgemäßen Speichervorrichtung.

Die Speichervorrichtung 10 besteht zunächst aus einem Speicherbehälter 11, in dem Wasserstoff gespeichert ist. Zur Erhöhung der Speicherkapazität befindet sich innerhalb des Speicherbehälters 11 eine Speichermasse 12. Die Speichermasse 12 besteht aus einer Anzahl von Konglomeraten, die aus Carbon-Nanofasern gebildet sind.

Weiterhin weist die Speichervorrichtung 10 eine Vorrichtung 20 zum Messen des Füllstands des im Speicherbehälter 11 gespeicherten Wasserstoffs auf. Die Meßvorrichtung 20 ist derart ausgebildet, daß sie die kernmagnetische Resonanz des Wasserstoffs messen kann. Die Meßvorrichtung 20 weist einen Meßkopf 21 auf, der aus einem Permanentmagneten 23 und einer Meßspule 22 gebildet ist. Der Permanentmagnet 23 ist ein Hufeisenmagnet, der die Meßspule 22 einschließt. Er dient zur Erzeugung eines konstanten statischen Magnetfelds. Über die Meßspule 22 wir ein elektromagnetisches Wechselfeld mit Radiofrequenz eingekoppelt, wobei die Feldlinien des statischen Magnetfelds und des elektromagnetischen Wechselfelds senkrecht aufeinander stehen.

Das elektromagnetische Wechselfeld wird in einem Sender 24 generiert, der über eine Brückenschaltung 25 und entsprechende Leitungen 28 mit der Meßspule 22 des Meßkopfs 21 verbunden ist.

Die Brückenschaltung 25 leitet die vom Meßkopf 21 gemessenen Werte der kernmagnetischen Resonanz, die auf weiter oben beschriebene Weise ermittelt wurden, über einen Verstärker 26 in eine Anzeigeeinrichtung 27, die im vorliegenden Fall als Zeigerinstrument ausgebildet ist. Dazu sind die einzelnen Elemente wiederum über Leitungen 28 miteinander verbunden. Weiterhin verhindert die Brückenschaltung 25, daß Signale vom Sender 24 direkt an den Verstärker 26 weitergeleitet werden, wodurch in diesem Gerät eine Beschädigung hervorgerufen werden könnte.

Alternativ können die einzelnen Aggregate, die vorstehend beschrieben wurden, auch als integrierte Schaltung ausgebildet sein oder mittels Mikrosystemtechnik hergestellt und zusammengebaut werden.

Nachfolgend wird nun die Funktionsweise der Meßvorrichtung 20 beschrieben.

Der Füllstand von Wasserstoff in einem Tanksystem, das einen mit Carbon-Nanofasern als Speichermasse 12 gefüllten Speicherbehälter 11 aufweist, soll mit der Meßvorrichtung 20 gemessen werden. Dazu wird zunächst über den Permanentmagneten 23 des Meßkopfs 21 ein konstantes statisches Magnetfeld erzeugt. Durch das statische Magnetfeld stellen sich die Kernspins des Wasserstoffs parallel oder antiparallel zum angelegten statischen Magnetfeld ein, wodurch zwei unterschiedliche Energieniveaus mit einer bestimmten Energiedifferenz entstehen. Um eine genaue Aussage über den Füllstand des Wasserstoffs machen zu können, muß der Meßkopf von einer für den gesamten Speicherbehälter 11 repräsentativen Menge des Wasserstoffs und auch der Speichermasse 12 durchdrungen sein.

Über die Meßspule 22 wird in den Meßkopf 21 ein variables elektromagnetisches Wechselfeld mit Radiofrequenz eingekoppelt, das zuvor im Sender 24 generiert wurde. Die Variation des elektromagnetischen Wechselfelds erfolgt über die Veränderung der Frequenz. Die Meßspule 22 und der Permanentmagnet 23 müssen derart zueinander ausgerichtet sein, daß die Feldlinien des statischen Magnetfelds und des elektromagnetischen Wechselfelds senkrecht aufeinander stehen.

Durch die Zuführung des elektromagnetischen Wechselfelds werden Kernspins des Wasserstoffs vom unteren ins obere Energieniveau befördert, wodurch die Energie des elektromagnetischen Wechselfelds absorbiert wird. Je mehr Kernspins sich innerhalb der Meßspule 22 befinden, desto mehr Energie kann absorbiert werden. Die absorbierte Energie ist somit direkt proportional zur Anzahl der Kernspins. Für das genannte Tanksystem bedeutet dies, daß die absorbierte Energie immer dann direkt proportional zum Füllstand des Speicherbehälters 11 ist, wenn sich innerhalb der Meßspule 21 ein repräsentativer Teil der Speichermasse und des gespeicherten Wasserstoffs befindet.

Die vom Meßkopf 21 gemessenen Werte der kernmagnetischen Resonanz des Wasserstoffs, beziehungsweise die Werte für die absorbierte Energie, werden über die Brückenschaltung 25 und den Verstärker 26 an die als Zeigerinstrument ausgebildete Anzeigeeinrichtung 27 weitergeleitet.

Je nach Bedarf können die gemessenen Werte vor ihrer Ausgabe an das Zeigerinstrument 27 noch in einer weiteren geeigneten Vorrichtung (nicht dargestellt), beispielsweise einem Computer oder dergleichen, aufbereitet und weiterverarbeitet werden.

Ein großer Vorteil der erfindungsgemäßen Speichervorrichtung ist darin zu sehen, daß der Meßkopf für die Durchführung der Messung der kernmagnetischen Resonanz völlig unabhängig ist von der Form und Größe des jeweiligen Speicherbehälters. Damit ist eine kostengünstige und qualitätsgesicherte Serienfertigung dieser Komonente möglich. Die Unterbringung des Meßkopfes im Speicherbehälter gewährleistet einen sehr guten Schutz vor Beschädigungen des Meßkopfes.

## Patentansprüche

1. Vorrichtung zum Speichern eines gasförmigen Mediums mit einem Speicherbehälter (11) zur Aufnahme des gasförmigen Mediums, wobei der Speicherbehälter(11) mit einer Speichermasse (12) zum Speichern des gasförmigen Mediums gefüllt ist,
**dadurch gekennzeichnet,**
- **daß** eine Meßvorrichtung zur Messung der kernmagnetischen Resonanz des im Speicherbehälter (11) befindlichen gasförmigen Mediums vorgesehen ist, wobei die Meßvorrichtung ein statisches Magnetfeld und ein elektromagnetisches Wechselfeld erzeugt, dessen Feldlinien senkrecht auf den Feldlinien des statischen Magnetfeldes stehen,
- **daß** die Meßvorrichtung einen Meßkopf (21) aufweist, in dem das statische Magnetfeld und das elektromagnetische Wechselfeld erzeugt werden, und
- **daß** der Meßkopf (21) innerhalb des Speicherbehälters (11) oder in einem mit dem Speicherbehälter (11) strömungstechnisch verbundenen Meßrohr in der Weise angeordnet ist, daß er ein Teilvolumen erfaßt, wobei das Teilvolumen hinsichtlich der Füllung mit der Speichermasse und dem gespeicherten gasförmigen Medium repräsentativ ist für den gesamten Speicherbehälter (11).

2. Vorrichtung nach Anspruch 1,
**dadurch gekennzeichnet,**
**daß** die Vorrichtung (20) ausgebildet ist zur Messung der kernmagnetischen Resonanz des gespeicherten Mediums nach der CW-Methode.

3. Vorrichtung nach Anspruch 1,
**dadurch gekennzeichnet,**
**daß** die Vorrichtung (20) ausgebildet ist zur Bestimmung der kernmagnetischen Resonanz des gespeicherten Mediums nach der Fouriertransform-Methode.

4. Vorrichtung nach Anspruch 1,
**dadurch gekennzeichnet,**
**daß** die Vorrichtung (20) ausgebildet ist zur Bestimmung der kernmagnetischen Resonanz des gespeicherten Mediums bei einem konstanten statischen Magnetfeld und einem konstanten elektromagnetischen Wechselfeld.

5. Vorrichtung nach einem der Ansprüche 1 bis 4,
**dadurch gekennzeichnet,**
**daß** der Meßkopf (21) eine Meßspule (22) aufweist und daß das elektromagnetische Wechselfeld über die Meßspule (21) eingekoppelt oder einkoppelbar ist.

6. Vorrichtung nach einem der Ansprüche 1 bis 5,
**dadurch gekennzeichnet,**
**daß** der Meßkopf (21) einen Elektromagneten, insbesondere einen supraleitenden Magneten, und/oder einen Permanentmagneten (23) aufweist, über den/die das statische Magnetfeld erzeugt oder erzeugbar ist.

7. Vorrichtung nach einem der Ansprüche 1 bis 6,
**dadurch gekennzeichnet,**
**daß** das elektromagnetische Wechselfeld eine Frequenz im Bereich von 10³ bis 10⁹ Hz, vorzugsweise im Bereich der Radiofrequenz, aufweist.

8. Vorrichtung nach einem der Ansprüche 1 bis 7,
**dadurch gekennzeichnet,**
**daß** ein Sender (24) zum Erzeugen des elektromagnetischen Wechselfelds vorgesehen ist.

9. Vorrichtung nach einem der Ansprüche 1 bis 8,
**dadurch gekennzeichnet,**
**daß** eine Anzeigeeinrichtung (27) vorgesehen ist.

10. Vorrichtung nach Anspruch 9,
**dadurch gekennzeichnet,**
**daß** der Anzeigeeinrichtung (27) ein Verstärker (26) vorgeschaltet ist.

11. Vorrichtung nach einem der Ansprüche 9 oder 10, sofern sie sich auf Anspruch 8 beziehen
**dadurch gekennzeichnet,**
**daß** eine Brückenschaltung (25) vorgesehen ist, über die der Meßkopf (21), der Sender (24) und die Anzeigeeinrichtung (27) miteinander gekoppelt sind.

12. Vorrichtung nach einem der Ansprüche 1 - 11,
**dadurch gekennzeichnet**,
daβ sie eine Einrichtung zur Erfassung der Temperatur des Mediums umfaßt.

13. Vorrichtung nach einem der Ansprüche 1 bis 12,
**dadurch gekennzeichnet,**
**daß** die Speichermasse (12) aus Carbon-Nanostrukturen, insbesondere aus Nanofasem, Nanoröhrchen oder Nanoschuppen gebildet ist.

14. Vorrichtung nach Anspruch 13,
**dadurch gekennzeichnet,**
**daß** die Carbon-Nanostrukturen gerichtete Struktur aufweisen und/oder bilden.

15. Vorrichtung nach Anspruch 13 oder 14,
**dadurch gekennzeichnet,**
**daß** die Carbon-Nanostrukturen zu größeren zusammenhängenden Konglomeraten verbunden sind.

16. Vorrichtung nach einem der Ansprüche 1 bis 15,
**dadurch gekennzeichnet,**
**daß** die Speichermasse (12) aus einer Anzahl von einzelnen zusammenhängenden Konglomeraten zusammengesetzt ist.

17. Vorrichtung nach Anspruch 15 oder 16,
**dadurch gekennzeichnet,**
**daß** zumindest einzelne Konglomerate mit gegenüber der Scheindichte der ursprünglich losen Carbon-Nanostrukturen erhöhter Scheindichte verdichtet sind, wobei die Scheindichte das auf das Volumen des konglomerats bezogene gewicht ist.

18. Vorrichtung nach einem der Ansprüche 1 bis 17,
**dadurch gekennzeichnet,**
**daß** das gasförmiger Medium Wasserstoff ist.

19. Verfahren zum Messen des Füllstands eines gasförmigen Mediums in einer Speichervorrichtung nach einem der Ansprüche 1 bis 18, mit folgendes Schritten:
a) Erzeugen eines statischen Magnetfelds und eines elektromagnetischen Wechsetfelds im Meßkopf, der im Speicherbehälter oder in einem mit dem Speicherbehälter strömungstechnisch verbundenen Meßrohr angeordnet ist;
b) Messen der kernmagnetischen Resonanz des gespeicherten Mediums über den Meßkopf, wobei der Meßkopf von einer repräsentativen Menge der Speichermasse und des gespeicherten gasförmigen Mediums durchdrungen ist; und
c) Anzeigen eines dem Füllstand entsprechenden Ergebnisses auf der Basis der gemessenen Werte in der Anzeigeeinrichtung.

20. Verfahren nach Anspruch 19,
**dadurch gekennzeichnet,**
**daß** die gemessenen Werte der kernmagnetischen Resonanz des gespeicherten Mediums vor dem Anzeigen in der Anzeigeeinrichtung aufbereitet und/oder weiterverarbeitet werden.

## Claims

1. Device for storing a gaseous medium, with a storage container (11) for receiving the gaseous medium, the storage container (11) being filled with a storage mass (12) for storing the gaseous medium, **characterised in that**
- a measuring device is provided for measuring the nuclear magnetic resonance of the gaseous medium which is situated in the storage container (11), the measuring device producing a static magnetic field and an electromagnetic alternating field, the field lines of which stand at right angles to the field lines of the static magnetic field,
- **in that** the measuring device has a measuring head (21), in which the static magnetic field and the electromagnetic alternating field are produced, and
- **in that** the measuring head (21) is disposed within the storage container (11) or in a measuring pipe which is connected fluidically to the storage container (11) in such a manner that it detects a partial volume, the partial volume being representative for the entire storage container (11) with respect to the filling with the storage mass and the stored gaseous medium.

2. Device according to claim 1,
**characterised in that**
the device (20) is configured for measuring the nuclear magnetic resonance of the stored medium according to the CW method.

3. Device according to claim 1,
**characterised in that**
the device (20) is configured for determining the nuclear magnetic resonance of the stored medium according to the Fourier transform method.

4. Device according to claim 1,
**characterised in that**
the device (20) is configured for determining the nuclear magnetic resonance of the stored medium with a constant static magnetic field and a constant electromagnetic alternating field.

5. Device according to one of the claims 1 to 4,
**characterised in that**
the measuring head (21) has a measuring coil (22), and **in that** the electromagnetic alternating field is coupled or can be coupled via the measuring coil (21).

6. Device according to one of the claims 1 to 5,
**characterised in that**
the measuring head (21) has an electromagnet, in particular a superconductive magnet, and/or a permanent magnet (23), via which the static magnetic field is produced or can be produced.

7. Device according to one of the claims 1 to 6,
**characterised in that**
the electromagnetic alternating field has a frequency in the range of 10³ to 10⁹ Hz, preferably in the radio frequency range.

8. Device according to one of the claims 1 to 7,
**characterised in that**
a transmitter (24) is provided for producing the electromagnetic alternating field.

9. Device according to one of the claims 1 to 8,
**characterised in that**
a display device (27) is provided.

10. Device according to claim 9,
**characterised in that**
the display device (27) is connected prior to an amplifier (26).

11. Device according to one of the claims 9 or 10, as long as they relate to claim 8,
**characterised in that**
a bridge circuit (25) is provided, via which the measuring head (21), the transmitter (24) and the display device (27) are connected to each other.

12. Device according to one of the claims 1 to 11,
**characterised in that**
it includes a device for detecting the temperature of the medium.

13. Device according to one of the claims 1 to 12,
**characterised in that**
the storage mass (12) is formed from carbon nanostructures, in particular from nanofibres, nanotubes or nanoshells.

14. Device according to claim 13,
**characterised in that**
the carbon nanostructures have and/or form a directional structure.

15. Device according to claim 13 or 14,
**characterised in that**
the carbon nanostructures are combined into larger cohesive conglomerates.

16. Device according to one of the claims 1 to 15,
**characterised in that**
the storage mass (12) is composed of a number of individual cohesive conglomerates.

17. Device according to claim 15 or 16,
**characterised in that**
at least individual conglomerates are compacted with an increased apparent density relative to the apparent density of the original loose carbon nanostructures, the apparent density being the weight relative to the volume of the conglomerate.

18. Device according to one of the claims 1 to 17,
**characterised in that**
the gaseous medium is hydrogen.

19. Method for measuring the level of a gaseous medium in a storage device according to one of the claims 1 to 18, with the following steps:
a) production of a static magnetic field and an electromagnetic alternating field in the measuring head, which is disposed in the storage container or in a measuring tube which is connected fluidically to the storage container;
b) measurement of the nuclear magnetic resonance of the stored medium via the measuring head, the measuring head being permeated by a representative quantity of the storage mass and of the stored gaseous medium; and
c) display of a result which corresponds to the level on the basis of the measured values in the display device.

20. Method according to claim 19,
**characterised in that**
the measured values of the nuclear magnetic resonance of the stored medium are processed and/or further processed prior to display in the display device.

## Revendications

1. Dispositif pour stocker un fluide gazeux, comportant un récipient de stockage (11) pour recevoir le fluide gazeux, le récipient de stockage (11) étant rempli d'une masse de stockage (12) pour stocker le fluide gazeux,
**caractérisé en ce que** :
- un dispositif de mesure pour mesurer la résonance magnétique nucléaire du fluide gazeux se trouvant dans le récipient de stockage (11) est prévu, le dispositif de mesure engendrant un champ magnétique statique et un champ alternatif électromagnétique, dont les lignes de champ sont orthogonales aux lignes de champ du champ magnétique statique,
- le dispositif de mesure présente une tête de mesure (21), dans laquelle sont engendrés le champ magnétique statique et le champ alternatif électromagnétique, et
- la tête de mesure (21) est agencée à l'intérieur du récipient de stockage (11) ou dans un tube de mesure relié, par une technique d'écoulement, au récipient de stockage (11), de façon qu'elle couvre un volume partiel, le volume partiel, relativement au remplissage avec la masse de stockage et le fluide gazeux stocké, étant représentatif pour le récipient de stockage (11) dans son ensemble.

2. Dispositif selon la revendication 1,
**caractérisé en ce que** le dispositif (20) est réalisé pour la mesure de la résonance magnétique nucléaire du fluide stocké selon le procédé CW.

3. Dispositif selon la revendication 1,
**caractérisé en ce que** le dispositif (20) est réalisé pour déterminer la résonance magnétique nucléaire du fluide stocké selon le procédé de la transformée de Fourier.

4. Dispositif selon la revendication 1,
**caractérisé en ce que** le dispositif (20) est réalisé pour déterminer la résonance magnétique nucléaire du fluide stocké pour un champ magnétique statique constant et un champ alternatif électromagnétique constant.

5. Dispositif selon une des revendications 1 à 4,
**caractérisé en ce que** la tête de mesure (21) présente une bobine de mesure (22), et **en ce que** le champ alternatif électromagnétique est modulé ou peut être modulé par la bobine de mesure (22).

6. Dispositif selon une des revendications 1 à 5,
**caractérisé en ce que** la tête de mesure (21) présente un électroaimant, en particulier un aimant supraconducteur, et/ou un aimant permanent (23), grâce auxquels le champ magnétique statique est engendré ou peut être engendré.

7. Dispositif selon une des revendications 1 à 6,
**caractérisé en ce que** le champ alternatif électromagnétique présente une fréquence dans la plage de 10³ à 10⁹ Hz, avantageusement dans la plage des radiofréquences.

8. Dispositif selon une des revendications 1 à 7,
**caractérisé en ce qu'**un émetteur (24) pour engendrer le champ alternatif électromagnétique est prévu.

9. Dispositif selon une des revendications 1 à 8,
**caractérisé en ce qu'**un dispositif d'affichage (27) est prévu.

10. Dispositif selon la revendication 9,
**caractérisé en ce qu'**un amplificateur (26) est prévu en amont du dispositif d'affichage (27).

11. Dispositif selon une des revendications 9 ou 10, dans la mesure où elles se rapportent à la revendication 8,
**caractérisé en ce qu'**un circuit à pont (25) est prévu, grâce auquel la tête de mesure (21), l'émetteur (24), et le dispositif d'affichage (27) sont couplés ensemble.

12. Dispositif selon une des revendications 1 - 11,
**caractérisé en ce qu'**il comporte un dispositif pour détecter la température du fluide.

13. Dispositif selon une des revendications 1 à 12,
**caractérisé en ce que** la masse de stockage (12) est formée de nanostructures de carbone, en particulier de nanofibres, de nanotubes ou de nano-nappes.

14. Dispositif selon la revendication 13,
**caractérisé en ce que** les nanostructures de carbone présentent et/ou forment une structure orientée.

15. Dispositif selon la revendication 13 ou 14,
**caractérisé en ce que** les nanostructures de carbone sont reliées en grands conglomérats adjacents.

16. Dispositif selon une des revendications 1 à 15,
**caractérisé en ce que** la masse de stockage (12) est constituée d'une pluralité de conglomérats adjacents individuels.

17. Dispositif selon le revendication 15 ou 16,
**caractérisé en ce qu'**au moins des conglomérats individuels sont comprimés avec une densité apparente augmentée par rapport à la densité apparente des nanostructures de carbone initialement lâches, la densité apparente étant le poids relatif au volume du conglomérat.

18. Dispositif selon une des revendications 1 à 17,
**caractérisé en ce que** le fluide gazeux est de l'hydrogène.

19. Procédé pour mesurer l'état de remplissage d'un fluide gazeux dans un dispositif de stockage selon une des revendications 1 à 18, comportant les étapes suivantes :
a) engendrer un champ magnétique statique et un champ alternatif électromagnétique dans la tête de mesure, qui est agencée dans le récipient de stockage ou dans un tube de mesure relié, par une technique d'écoulement, au récipient de stockage ;
b) mesurer la résonance magnétique nucléaire du fluide stocké par la tête de mesure, la tête de mesure étant traversée par une quantité représentative de la masse de stockage et du fluide gazeux stocké ; et
c) afficher un résultat, correspondant à l'état de remplissage, sur la base des valeurs mesurées, sur le dispositif d'affichage.

20. Procédé selon la revendication 19,
**caractérisé en ce que** les valeurs mesurées de la résonance magnétique nucléaire du fluide stocké sont préparées et/ou traitées avant l'affichage sur le dispositif d'affichage.
